Europäisches Patentamt

European Patent Office

Office européen des brevets

(19)

(11) Publication number: **0 163 830**
A2

# (12) EUROPEAN PATENT APPLICATION

(21) Application number: 85103346.4

(22) Date of filing: 22.03.85

(51) Int. Cl.⁴: **H 01 L 23/52**, H 01 L 21/48

(30) Priority: 06.04.84 US 597301

(43) Date of publication of application: **11.12.85 Bulletin 85/50**

(84) Designated Contracting States: **DE FR GB IT**

(71) Applicant: **International Business Machines Corporation, Old Orchard Road, Armonk, N.Y. 10504 (US)**

(72) Inventor: **Lee, Sue Thu-Er, One Crescent Drive, Apalachin New York 13732 (US)**
Inventor: **Wen, Sheree Hsiao-Ru, 1355 Quarry Drive, Mohegan Lake New York 10547 (US)**

(74) Representative: **Lewis, Alan John, IBM United Kingdom Patent Operations Hursley Park, Winchester, Hants, S021 2JN (GB)**

(54) **Multi-layer integrated circuit substrates and method of manufacture.**

(57) A thin film composite structure consists of at least two layers (M1, M2) of electrical wiring (11, 15) composed of a metal such as copper separated from each other for the most part by an intervening layer of an insulating material such as polyimide. A layer (12, 14) of a composite of an adhesion metal and a conductive metal (Cr–Cu "blend") is interposed between the copper wiring (11, 15) and the insulating material (13) as well as between the copper wiring where they join in regions (16) where the dielectric has been opened to form vias and other electrical junction points between the layers. The preferred composition of the "blend" is in the range from 5–95 atomic percent Cr and 95–5 atomic percent Cu although other metals can be combined with each. The purpose of the thin "blend" film is to enhance the adhesion of the layers while not increasing the resistance of the contacts between the upper and lower conducting layers, at the vias and other electrical junction points.

INTEGRATED CIRCUITS AND THEIR METHOD

OF MANUFACTURE

The present invention relates to large scale intergration
circuit devices and more particularly to wiring for electrical
systems employing such devices.

In the making of a multi-layer integrated circuit substrate,
there has evolved a, so called, MCP or metallized ceramic
polyimide structure. This structure comprises a ceramic
substate on which is evaporated a first layer M1 of
chrome-copper-chrome on which printed circuitry is formed on the
copper, a layer of polyimide, and a second evaporated layer M2
of chrome-copper-chrome on which printed circuitry is formed on
the copper. Via holes are formed in the polyimide, prior to the
deposition of the M2 layer, which extend down to the copper
circuitry of the M1 layer and which conductively connect the
circuitry on the M1 and M2 layers.

The above basic structure has presented problems in that there
is no solubility of copper in chrome and, as a result, in the
vias the bond between the copper of the M1 layer and the chrome
of the M2 layer is a mechanical bond or coupling. Also, the top
chrome of layer M1 is removed chemically at the bottom of the
vias leaving copper which is exposed to air prior to the
deposition of the M2 layer which results in oxidation. As such,
this bonding systems which depends entirely on a mechanical
coupling and is extremely sensitive to film oxidation and/or
contaminants at the metal to metal interface did not provide the
desired adhesion and also created undue electrical resistance in
the vias.

1

Our prior specification US-A-4386116 addresses these
difficulties and discloses eliminating the first or bottom
chrome layer of the M2 evaporation and using a substrate
temperature of 360° - 380° during the evaporation of the M2
layer of chrome-copper. We have found that such structures
provide a level of adhesion which is less than currently
desired. Greater levels of adhesion are required which will
retain integrity of the structure subsequent to the
manufacturing process and in commercial use.

Our second prior specification US-A-4290079 discloses a
structure which includes no polyimide and which uses phased CuCr
as a transition between Cr adhesion layers (adhering to diffused
silicon and silicon dioxide) and copper conductors on the one
hand and a thin layer of copper and a thin layer of gold at the
solder bonding site. The thin layers of copper and gold joined
by the second layer of phased CuCr blend are consumed by the
soldering of the solder ball, but the CuCr blend serve as a
barrier in the Ball Limiting Metallurgy (BLM) to protect the
integrity of the thicker copper layer below from the molten
solder. The copper and chrome are phased with the heaters to
the Cr source and the Cu source in the evaporator turned on and
off at different times. ".... the heat to the copper source is
left on while the heater to the chromium is turned on.
Subsequently the heater to the chromium is turned off. Thus
both chromium and copper are simultaneously deposited for an
interval of time, followed by the deposition of a pure copper
layer. The phase Cr-Cu layers have a thickness in the range from 500 to 1500 Angstroms. First, this is a soldering system which differs from our invention which does not relate to soldering. Second, the blend of Cr-Cu is employed only between the Cr and Cu layers. Third, only chromium is in contact with the polyimide. Fourth, it is used as a barrier between the molten solder and the copper layer.

It is an object of the invention to provide an improved integrated circuit assembly and an improved process for making such assemblies.

Accordingly the invention provides an integrated circuit assembly comprising a buffer layer interposed between a first conducting layer and dielectric layer, characterised in that said buffer layer is contiguous with and directly contacts one surface of the dielectric layer, in that said buffer layer comprises a first metal exhibiting a strong adhesion to the dielectric layer and a second metal having a relatively high electrical conductivity and in that the second metal is distributed throughout the buffer layer to provide electrical continuity with high conductivity between the opposed faces of that layer.

The invention also provides a process for making an integrated circuit assembly comprising a buffer layer interposed between a first conducting layer and a dielectric layer, said process comprising forming said first conducting layer on a planar support; forming a buffer layer over said conducting layer by simultaneously depositing thereon a first metal exhibiting a strong adhesion to the material of the dielectric layer and a second metal exhibiting a relatively high electrical conductivity, said co-deposition being carried out so that the second metal is distributed throughout the buffer layer to provide electrical continuity with high conductivity between the

3

0163830

opposed faces of that layer; and applying a layer of the dielectric material over the buffer layer.

The invention further provides a process for making an integrated circuit assembly comprising a buffer layer interposed between a dielectric layer and a conducting layer, said process comprising providing a dielectric layer; forming a buffer layer over said dielectric layer by simultaneously depositing thereon a first metal exhibiting a strong adhesion to the material of the dielectric layer and a second metal exhibiting a relatively high electrical conductivity, said co-deposition being carried out so that the second metal is distributed throughout the buffer layer to provide electrical continuity with high conductivity between the opposed faces of that layer; forming a conducting layer on the buffer layer.

The invention furthermore provides a process for making a multilayer integrated circuit assembly, said process comprising forming said first conducting layer on a planar support; forming a buffer layer over said conducting layer by simultaneously depositing thereon a first metal exhibiting a strong adhesion to the material of the dielectric layer and a second metal exhibiting a relatively high electrical conductivity, said co-deposition being carried out so that the second metal is distributed throughout the buffer layer to provide electrical continuity with high conductivity between the opposed faces of that layer; applying a layer of the dielectric material over the buffer layer; forming a second buffer layer over said dielectric layer by simultaneously depositing thereon a first metal exhibiting a strong adhesion to the material of the dielectric layer and a second metal exhibiting a relatively high electrical conductivity, said co-deposition being carried out so that the second metal is distributed throughout the buffer layer to provide electrical continuity with high conductivity between the

4

opposed faces of that layer; and forming a conducting layer on the buffer layer.

The invention will now be further described with reference to the accompanying drawings in which:-

FIG 1 shows a via connection in a multilayer wiring structure employing the improved metallurgy of this invention.

FIG. 2 shows peel strength (gms/mm) for a codeposited layer deposited by electron beam coevaporation.

FIGS. 3A-3D shows photographs of the fractured surface of polyimide beneath a metallic film peeled from a polyimide substrate.

In the drawings, like elements are designated with similar reference numbers,a nd identical elements in different specific embodiments are designated by identical reference numbers.

## DESCRIPTION OF THE PREFERRED EMBODIMENT

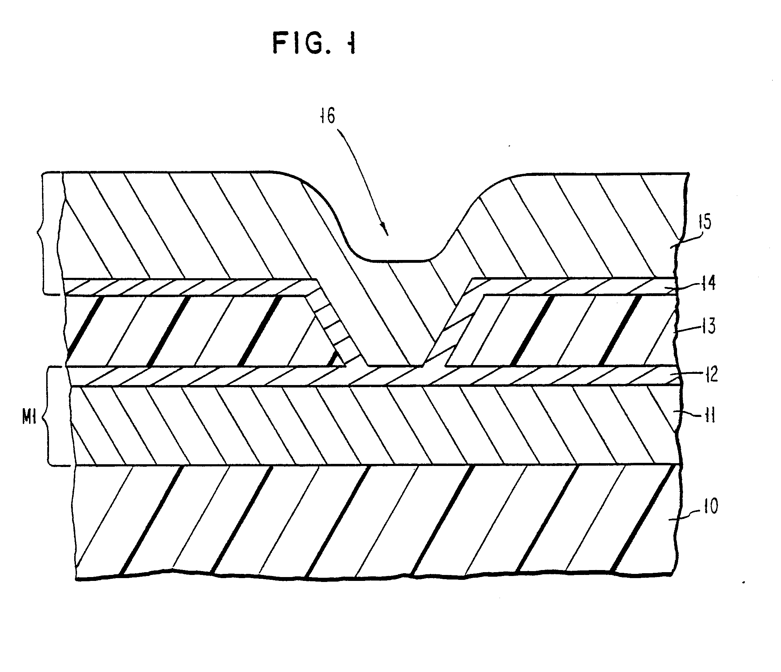

FIG. 1 is a sectional view of a metallurgical structure for wiring fabricated in accordance with this invention.  A substrate 10 composed of a dielectric such as polyimide is coated with a layer of copper serving as a conductor 11.  The usual adhesion layer e.g. a chromium layer, (not shown) is formed on the polyimide layer 10 to prevent peeling of the copper 11.  Layer 11 in turn is coated with a codeposited, combined or composite layer 12 of a conductive metal and a metal adapted to bond to polyimide or a substitute dielectric layer 13.  For example a layer of a conductor metal can be deposited on the conductor layer 11 and then can be caused by whatever means to be perforated or have myriad apertures formed in the structure by means of etching or radiation or mechanical means

5

so that another metal serving as a bonding agent can be deposited within the apertures, holes or perforations in the first layer 11 of conductive metal. Conversely, the bonding metal can be deposited first and then the conductive metal can be deposited within the apertures, perforations or holes in the bonding metal.

Above the layer 12 is deposited a layer 13 of a dielectric such as polyimide which in turn is coated with another layer 14 of composite or codeposited or combined metals similar to layer 12 or identical to layer 12, one of which metals readily conducts electricity at a low resistance and the other of which metals affords excellent bonding to the polyimide or other dielectric layer 13. The upper layer 15 is an excellent conductor such as copper.

In layers 12 and 14 one or more metals in a first set are interlinked with one or more metals in a second set into a composite, combined or codeposited structure. The first set of metals are adhesion metals which readily adhere to both the conductors and the dielectric layers to be employed in the structure. Thus the metal included in the codeposited structure from the first set of metals can comprise one or more of the adhesion promoting metals such as chromium, titanium, manganese, vanadium, niobium, molybdenum hafnium, tungsten, tantalum, nickel, or aluminum.

The metal in the codeposited structure from the second set of metals can comprise one or more conductive metals (such as copper, silver or gold.)

The metals (from the first set of metals and from the second set of metals), which are codeposited as stated above, are provided in a double irregular intertwined, interwoven, or interspersed structure of the first metal and the second metal which are irregularly linked. Here the adhesion is provided by the first metal which bonds to the dielectric such as polyimide.

7

Excellent conductive properties are provided by the copper or other conductive metal which is interwoven in a separate interlinked network surrounded with the first metal.

Thus excellent electrical conductivity is afforded, since current can pass through the conductive channel formed by the metal or metals selected from the second set.

The preferred composition of the codeposited metals in layers 12 and 14 in FIG. 1 is in the range of 5-95% Cr and 95-5% Cu, depending upon the product requirements while maintaining a balance between adhesion and conductivity.

The combination of metals codeposited include a first metal grouping which have excellent bonding properties to the dielectric materials. Some metals which provide such adhesion include Al, Ti, V, Cr, Mn, Ni, Nb, Mo, Hf, Ta, and W. and a more highly conductive group of metals such as Cu, Ag and Au.

This type of structure is adapted for use in electronic packaging involving Cu conductors and polymer insulators. It provides a unique combination of good adhesion (polymer-conductor) without comprising via resistance.

A bonding layer such as the Cr/Cu blend can be employed as an interface metallurgy for Large Scale Integration (LSI) electronic devices, including both wiring and packaging.

Data discussed below indicates that this material satisfies two key criteria which follow:

1. The adhesion strength of the Cr/Cu blend polyimide structure has been demonstrated to be over an order of magnitude greater than that measured when the blend layer is omitted;

2. The via resistance obtained meets the requirements of LSI devices.

PRODUCTION OF CR/CU BLEND.

Two exemplary methods used to deposit Cr/Cu blend layers are discussed next: dual electron beam evaporation and resistance heating flash evaporation.

9

## METHOD OF MANUFACTURE

### (A) DUAL ELECTRON BEAM COEVAPORATED MATERI-AL

The dual electron beam evaporation process employs two individually controlled electron guns for Cr and Cu evaporation. The power of the electron guns ramp up for Cr and Cu evaporation with the two individual shutters closed. The coevaporation starts by opening the two shutters simultaneously after the power of the electron guns reaches predetermined steady states. The vacuum in the chamber is in the $10^{-8}$ range.

For comparison, 0%Cr-100%Cu, 25%Cr-75%Cu, 50%Cr-50%Cu, 75%Cr-25%Cu, 100%Cr compositions were chosen for microstructure, adhesion strength, and via resistance studies.

### (B) RESISTANCE HEATING FLASH EVAPORATED MATERIALS

The resistance heating flash evaporation is accomplished by a high power short pulse which vaporizes Cr and Cu in seconds. The source material is millimeter sized chunks of pure Cr and pure Cu.

0163830

A Cr-Cu solid solution can be obtained by use of an electron beam, thermal coevaporation, chemical vapor deposition, ion beam sputtering, and radio frequency or magnetron sputtering among other methods of codeposition.


## ADHESION RESULTS AND MECHANISMS

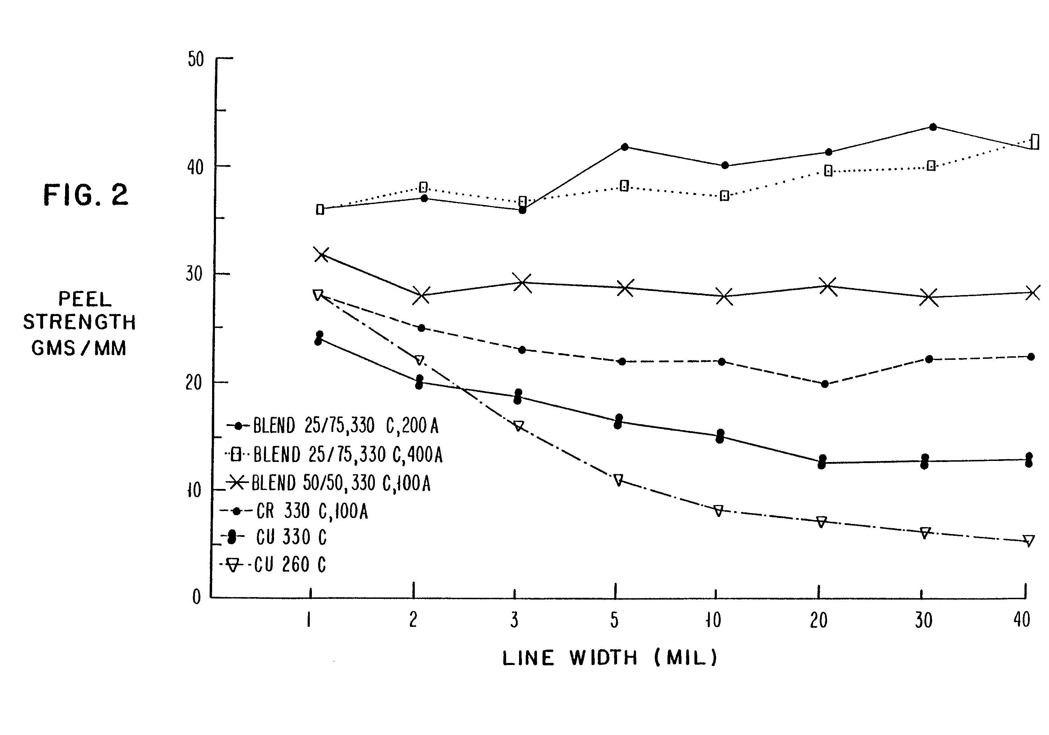

The peel test data for and electron beam coevaporation is shown in FIG.2. The peel strength of Cr/Cu blend film is superior to a pure Cr interface layer or Cu -polyimide interface layers without any additional mixture. The 25%Cr-75%Cu demonstrated better peel test data than 50%Cr-50%Cu. In contrast to Cu-polyimide interface layers, the Cr, or Cr-Cu structure interface does not exhibit a line width effect.

The peel test data of flashed Cr/Cu blend film which was evaporated demonstrated a range of 40 to 70 g/mm peel strength on various different substrates.

In fact, by using Scanning Auger Microprobe, (SAM), X-ray photoelectric spectroscopy (XPS), optical microscopy, and interferometry we found the adhesion of CrCu blend film to polyimide is so good that the separation always occurs either inside the polyimide or between the polyimide or the ceramic

11

substrates.  A key implication of this result is that the adhesion of Cr-Cu to polyimide is stronger than the polyimide to itself.

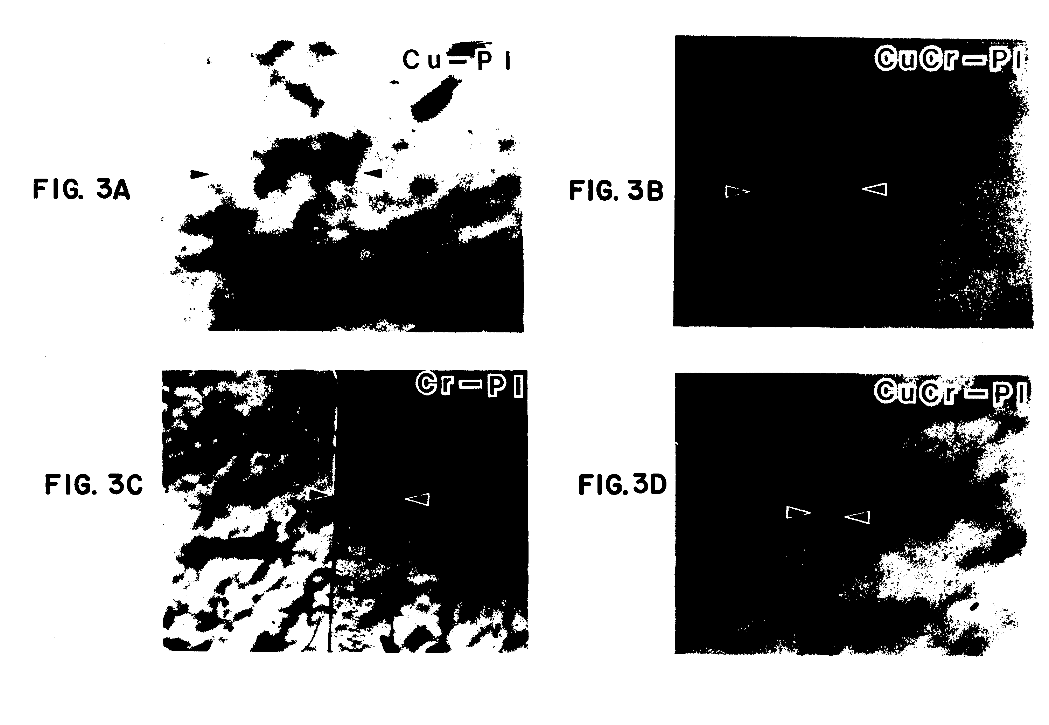

FIGS. 3A, B, C, D show the fractured surface on polyimide, resulting from various different treatments. First each sample of polyimide had a metallic film deposited on it.  Then the metal film was peeled off the polyimide substrate. The photographs show the results after the metal film has been peeled off from the substrates.

FIG. 3A shows very little change in the film surface if Cr  is not present.

FIG. 3B shows the marks created by a flashed (formed by resistance heating) blend layer.

FIG. 3C shows the marks created by a flashed thin Cr interface layer.

FIG. 3D shows a deep trench inside the polyimide for the electron beam coevaporated blend interface.

This data clearly demonstrates that strong bonding interaction occurred between the polyimide and the metal at the interface therebetween and created a ditch

12

during. the presence of Cr (in the metal) at the interface.

## VIA RESISTANCE

The as prepared via resistances of the Cr/Cu blend and Cu film are indistinguishable. No change has been observed after 2000 hours of temperature and humidity testing.

There is no corrosion effect at the underside of the metal lines when Cr/Cu blend is used. The passivation of Cr at the surface creates a barrier against chemical attack. This barrier is essential to protect the integrity of lines against aggressive chemical environments.

13

CLAIMS

1.   An integrated circuit assembly comprising a buffer layer
(12) interposed between a first conducting layer (11) and
dielectric layer(13), characterised in that said buffer layer
(12) is contiguous with and directly contacts one surface of the
dielectric layer (13), in that said buffer layer (12) comprises
a first metal exhibiting a strong adhesion to the dielectric
layer (13) and a second metal having a relatively high
electrical conductivity and in that the second metal is
distributed throughout the buffer layer to provide electrical
continuity with high conductivity between the opposed faces of
that layer.

2.   An assembly as claimed in claim 1, further characterised in
that a second buffer layer, as aforesaid, directly contacts the
other surface of the dielectric layer and is interposed between
a second conducting layer and the dielectric layer.

3.   An assembly as claimed in claim 2, further characterised in
that the first and second conductors are electrically connected
by a portion of the second buffer layer which lines a via hole
in the dielectric layer and extends therethrough to join the
first buffer layer.

4.   An assembly as claimed in claim 1, 2 or 3, further
characterised in that the first metal comprises chromium,
titanium, manganese, vanadium, niobium, molybdenum, hafnium,
tungsten, tantalum, nickel, or aluminium.

5.   An assembly as claimed in claim 1, 2, 3 or 4, further
characterised in that the second metal comprises copper, gold or
silver.

14

0163830

6. An assembly as claimed in any one of claims 1 to 5, further characterised in that the dielectric layer comprises a polymer, a ceramic or a glass material.

7. An assembly as claimed in any one of claims 1, 2 or 3, further characterised in that the first metal is chromium and is present in the buffer layer in the proportion 5 to 95 atomic percentage and in that the second metal is copper and is present in the proportion 95 to 5 atomic percentage.

8. A process for making an integrated circuit assembly comprising a buffer layer interposed between a first conducting layer and a dielectric layer, said process comprising forming said first conducting layer on a planar support; forming a buffer layer over said conducting layer by simultaneously depositing thereon a first metal exhibiting a strong adhesion to the material of the dielectric layer and a second metal exhibiting a relatively high electrical conductivity, said co-deposition being carried out so that the second metal is distributed throughout the buffer layer to provide electrical continuity with high conductivity between the opposed faces of that layer; and applying a layer of the dielectric material over the buffer layer.

9. A process for making an integrated circuit assembly comprising a buffer layer interposed between a dielectric layer and a conducting layer, said process comprising providing a dielectric layer; forming a buffer layer over said dielectric layer by simultaneously depositing thereon a first metal exhibiting a strong adhesion to the material of the dielectric layer and a second metal exhibiting a relatively high electrical conductivity, said co-deposition being carried out so that the second metal is distributed throughout the buffer layer to provide electrical continuity with high conductivity between the opposed faces of that layer; and applying a layer of the

15

0163830

dielectric material over the buffer layer and forming a conducting layer on the buffer layer.

10. A process for making a multilayer integrated circuit assembly, said process comprising forming said first conducting layer on a planar support; forming a buffer layer over said conducting layer by simultaneously depositing thereon a first metal exhibiting a strong adhesion to the material of the dielectric layer and a second metal exhibiting a relatively high electrical conductivity, said co-deposition being carried out so that the second metal is distributed throughout the buffer layer to provide electrical continuity with high conductivity between the opposed faces of that layer; applying a layer of the dielectric material over the buffer layer; forming a second buffer layer over said dielectric layer by simultaneously depositing thereon a first metal exhibiting a strong adhesion to the material of the dielectric layer and a second metal exhibiting a relatively high electrical conductivity, said co-deposition being carried out so that the second metal is distributed throughout the buffer layer to provide electrical continuity with high conductivity between the opposed faces of that layer; and forming a conducting layer on the buffer layer.

11. A process as claimed in claim 10, further comprising forming a via hole through the dielectric layer to expose the first buffer layer therethrough before forming the second buffer layer, and thereafter forming the second buffer layer to include a portion lining the via hole and electrically joined to the exposed region of the first buffer layer.

16

## FIG. 1

FIG. 2

PEEL
STRENGTH
GMS / MM

Legend:
- BLEND 25/75,330 C,200 A
- BLEND 25/75,330 C,400A
- BLEND 50/50,330 C,100A
- CR 330 C,100A
- CU 330 C
- CU 260 C

LINE WIDTH (MIL)

2/3

0163830

FIG. 3A  Cu—PI

FIG. 3B  CuCr—PI

FIG. 3C  Cr—PI

FIG. 3D  CuCr—PI